# EUROPEAN PATENT SPECIFICATION

(11) **EP 4 231 465 B1**
(45) Date of publication and mention of the grant of the patent: **08.10.2025**
(21) Application number: 22173538.4
(22) Date of filing: 16.05.2022
(51) Int. Cl.: H01R 13/52, H02G 3/08, H01R 13/512, H01R 24/64

(54) **ELECTRONIC DEVICE AND WATERPROOF MEMBER THEREOF**
ELEKTRONISCHE VORRICHTUNG UND WASSERDICHTES ELEMENT DAVON
DISPOSITIF ÉLECTRONIQUE ET SON ÉLÉMENT ÉTANCHE À L'EAU

(30) Priority: 17.02.2022 TW 111105762
(43) Date of publication of application: 23.08.2023
(73) Proprietor: WNC Corporation, Hsinchu 308 (TW)
(72) Inventor: CHEN, Te-Wei, Hsinchu (TW); CHOU, Kai-Hsiang, Hsinchu (TW)
(74) Representative: Ter Meer Steinmeister & Partner

(56) References cited:
- CN-U- 206 471 580
- CN-U- 208 127 519
- JP-A- 2010 086 766
- US-A- 5 395 266

## Description

This application claims the benefit of priority to Taiwan Patent Application No. 111105762, filed on February 17,2022.

### BACKGROUND OF THE INVENTION

### Field of the Invention

The present disclosure relates to a waterproof member, and more particularly, to a waterproof member of an electronic device.

### Description of the Related Art

With the development of wireless communication technology, outdoor network repeaters are also gradually used. Since outdoor network repeaters are affected by outdoor environment and so are prone to problems related to vapor, dust, etc., they must be equipped with a cable gland to prevent contaminations. Conventional cable glands not only have complex structures and high cost, they are also difficult to assemble and disassemble, and so it is troublesome for users when working with network cables.

CN 206 471 580 U discloses a printer with a waterproof network port, including a printer body. The printer body is provided with a network cable port for connecting to a network cable connector. The network cable port is provided with a base sealing structure, and the network cable connector is provided with a base sealing structure. An upper cover sealing structure is provided. The upper cover sealing structure cooperates with the base sealing structure to form an axial chamber. The network cable connector passes through the axial chamber and is connected to the network cable port; the base sealing structure Covering the gap between the network cable port and the printer body; the upper cover sealing structure is disposed close to the network cable connector, the upper cover sealing structure has an upper cover sealing gasket, and the upper cover sealing gasket is pressed against the A sealing fit is formed on the base sealing structure, the upper cover sealing gasket wraps the mesh wire to form a sealing fit, and the axial chamber is a sealing chamber

JP 2010 086766 A discloses a dustproof bush that is attached to a modular plug, and a dustproof cover that is attached to a device or panel surface that has an insertion slot for a modular jack that connects the plug. a holder portion having a thickness for holding a dustproof bushing, an opening for fitting the dustproof bushing in the holder portion, the opening being a fitting hole passing through an insertion opening of the modular jack, and the fitting hole; The opening of the dustproof bushing is made of an elastic material and is attached to the modular plug, covering the rear part of the plug to expose the connection part with the modular jack at the tip. At the same time, a protrusion is formed around the bush, and a modular plug equipped with a dust-proof bush is inserted into the insertion hole of a dust-proof cover attached to the device or panel surface, and the connection part at the tip of the plug is inserted. A dustproof structure for a modular jack in which a protrusion formed around a dustproof bush closes a gap between the bush and a tapered surface of an opening when connected to the modular jack.

CN 208 127 519 U discloses a crystal head socket, used for fixedly connecting crystal heads and wires. The crystal head socket includes a panel and a socket body. The panel is provided with a plug-in gap, and the panel is also provided with a card slot.

US 5 395 266 A discloses a water-proofing plug for a connector which comprises: rubber plug including a cylinder having an electric wire inserting hole along the central axis, and a sealing portion 12c formed on the outer surface of one end portion of the cylinder in such a manner that the sealing portion is brought into close contact with the inner surface of a connector housing; and a reinforcing member including base plate having an electric wire inserting hole at the center, and supporting arms extending from both sides of the base plate, is so improved that the end faces of the supporting arms are sloped towards the electric wire inserting hole of the base plate, whereby the water-proofing plug is excellent in water-proofing ability and high in reliability in practical use.

### BRIEF SUMMARY OF THE INVENTION

So, it is an object of the present invention to provide an electronic device having a less complex structure and/or causes reduced costs for manufacturing.

The object is solved by the features of the independent claims. Preferred embodiments are given in the dependent claims.

In view of the aforementioned issues, an electronic device is provided, which includes a device body, a cable, and a waterproof member as mentioned below. The device body includes a socket. The cable includes a plug unit and a cable body. The plug unit is disposed at one end of the cable body and is adapted to be connected to the socket. The waterproof member is sleeved over at least a portion of the plug unit. The waterproof member includes an elastic material.

It is another aspect a waterproof member is provided that is adapted to be sleeved over a cable. The waterproof member includes a member body. A through hole is formed in the member body. The cable includes a plug unit and a cable body. The plug unit is disposed at one end of the cable body. When the plug unit is inserted to pass through the through hole, the waterproof member is sleeved over at least a portion of the plug unit. The waterproof member may comprise a through hole, a first enclosed rib with a first inner diameter, and a second enclosed rib with a second inner diameter, the first enclosed rib and the second enclosed rib are formed in the through hole, the first enclosed rib is located between the second enclosed rib and the abutting surface, and the first inner diameter is smaller than the second inner diameter.

Preferably, the waterproof member is made of elastic material, such as rubber. The waterproof member of the present disclosure has a simple structure and low cost and is easy to assemble. Moreover, the waterproof member of the present disclosure is adaptable to most types of cables for providing waterproof and dustproof protections, and is convenient and easy to assemble or disassemble by users.

In one or more embodiments, the electronic device may further comprise a housing and a cover lid.

In one or more embodiments, the device body may be disposed inside the housing, and the waterproof member is disposed inside the cover lid.

In one or more embodiments, the cover lid may comprise a mounting slot.

The waterproof member may be disposed in the mounting slot.

In one or more embodiments, the waterproof member may be tightly fitted to an inner wall of the mounting slot.

In one or more embodiments, the device body may comprise a body surface.

In one or more embodiments, the socket may be located on the body surface.

In one or more embodiments, the waterproof member may comprise an abutting surface, and the abutting surface is in contact with the body surface.

In one or more embodiments, the waterproof member may comprise a rib and a flange

In one or more embodiments, the abutting surface may be located on the flange.

In one or more embodiments, the flange may be located at one end of the waterproof member.

In one or more embodiments, the rib may be located at another end of the waterproof member.

In one or more embodiments, the rib may be tightly fitted to the inner wall of the mounting slot.

In one or more embodiments, the cover lid may be fastened to the body surface.

In one or more embodiments, the plug unit may comprise a registered jack and a protective sheath.

In one or more embodiments, the cable body may be connected to the registered jack.

In one or more embodiments, the protective sheath may be disposed on the cable body and may abut the registered jack.

In one or more embodiments, the waterproof member may be sleeved over the protective sheath.

In one or more embodiments, the first enclosed rib may comprise a first width.

In one or more embodiments, the second enclosed rib may comprise a second width.

In one or more embodiments, the first width may be smaller than the second width.

In one or more embodiments, the through hole may further comprise an enlarging portion.

In one or more embodiments, the second enclosed rib may be located between the enlarging portion and the first enclosed rib.

In one or more embodiments, the plug unit may comprise a registered jack connected to the cable body.

In one or more embodiments, the waterproof member may be sleeved over the registered jack and the cable body.

In one or more embodiments, the waterproof member comprises a through hole, a first enclosed rib, and a second enclosed rib.

In one or more embodiments, the first enclosed rib and the second enclosed rib are formed in the through hole.

In one or more embodiments, the first enclosed rib is located between the second enclosed rib and the abutting surface and may abut the registered jack.

In one or more embodiments, the second enclosed rib may abut the cable body.

In one or more embodiments, the plug unit may comprise a registered jack and a protective sheath.

In one or more embodiments, the cable body may be connected to the registered jack.

In one or more embodiments, the protective sheath may be disposed on the cable body and may abut the registered jack.

In one or more embodiments, the waterproof member may be sleeved over the protective sheath.

In one or more embodiments, the waterproof member comprises an abutting surface, a first enclosed rib, and a second enclosed rib.

In one or more embodiments, the first enclosed rib and the second enclosed rib are formed in the through hole.

In one or more embodiments, the first enclosed rib is located between the second enclosed rib and the abutting surface.

In one or more embodiments, the first enclosed rib comprises a first inner diameter.

In one or more embodiments, the second enclosed rib comprises a second inner diameter.

In one or more embodiments, the first inner diameter is smaller than the second inner diameter.

In one or more embodiments, the first enclosed rib may comprise a first width, the second enclosed rib comprises a second width.

In one or more embodiments, the first width may be smaller than the second width.

In one or more embodiments, the through hole may further comprise an enlarging portion.

In one or more embodiments, the second enclosed rib may be located between the enlarging portion and the first enclosed rib.

In one or more embodiments, the plug unit may comprise a registered jack connected to the cable body.

In one or more embodiments, the waterproof member may be sleeved over the registered jack and the cable body.

In one or more embodiments, the first enclosed rib and the second enclosed rib are formed in the through hole, the first enclosed rib is located between the second enclosed rib and the abutting surface and may abut the registered jack, and the second enclosed rib may abut the cable body.

In one or more embodiments, the waterproof member may further comprise a rib and a flange.

In one or more embodiments, the flange may be located at one end of the member body, the rib may be located at another end of the member body.

In one or more embodiments, the flange may comprises a recess.

In one or more embodiments, the plug unit may comprises a registered jack with an elastic arm.

In one or more embodiments, the elastic arm may be adapted to be placed in the recess.

### BRIEF DESCRIPTION OF THE DRAWINGS

The present invention can be more fully understood by reading the subsequent detailed description and examples with references made to the accompanying drawings, wherein:
FIG. 1A is a schematic perspective view of an electronic device according to a first embodiment of the present disclosure;
FIG. 1B is a schematic partially exploded view of an electronic device according to a first embodiment of the present disclosure;
FIG. 1C is a schematic perspective view illustrating detailed structure of a cover lid according to a first embodiment of the present disclosure;
FIG. 2A is a schematic cross-sectional view illustrating main structure of an electronic device according to a first embodiment of the present disclosure;
FIG. 2B is a schematic cross-sectional view of a waterproof member according to a first embodiment of the present disclosure;
FIG. 2C is a schematic front view of a waterproof member of a first embodiment of the disclosure;
FIG. 3A is a schematic cross-sectional view illustrating main structure of an electronic device according to a second embodiment of the present disclosure;
FIG. 3B is a schematic cross-sectional view of a waterproof member according to a second embodiment of the present disclosure;
FIG. 4A is a schematic perspective view of a waterproof member according to a second embodiment of the present disclosure; and
FIG. 4B illustrates a waterproof member according to a second embodiment of the present disclosure being connected with a cable.

### DETAILED DESCRIPTION OF THE INVENTION

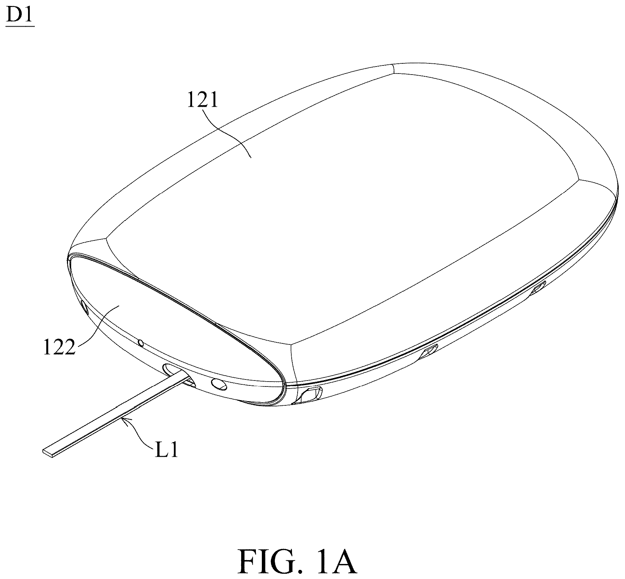

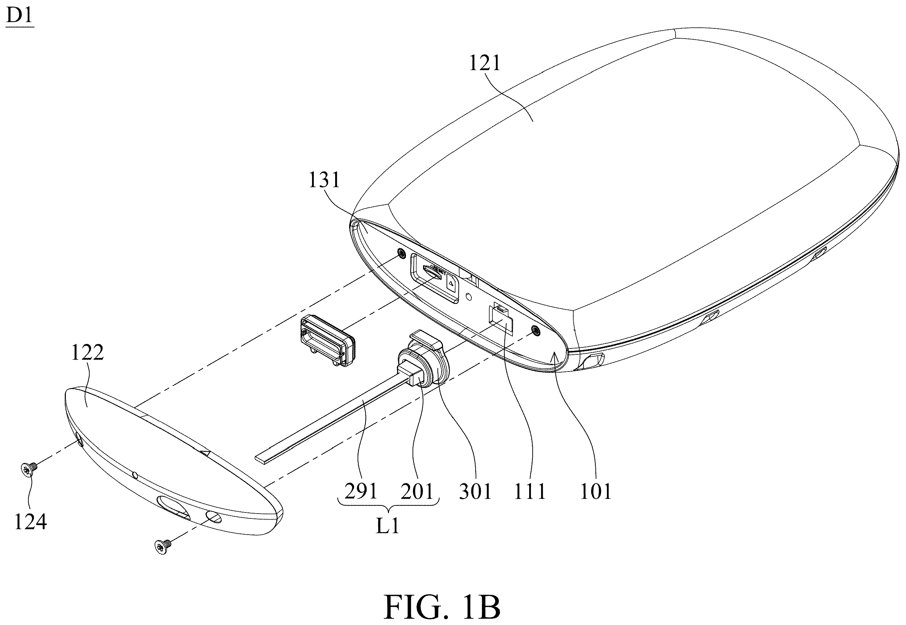

Referring to FIG. 1A and FIG. 1B, an electronic device D1 includes a device body 101, a cable L1, and a waterproof member 301. The device body 101 includes a socket 111. The cable L1 includes a plug unit 201 and a cable body 291, and the plug unit 201 is disposed at one end of the cable body 291 and adapted to be connected to the socket 111. The waterproof member 301 is sleeved over at least a portion of the plug unit 201.

In one embodiment, the electronic device D1 further includes a housing 121 and a cover lid 122. The device body 101 is disposed inside the housing 121, and the waterproof member 301 is disposed inside the cover lid 122.

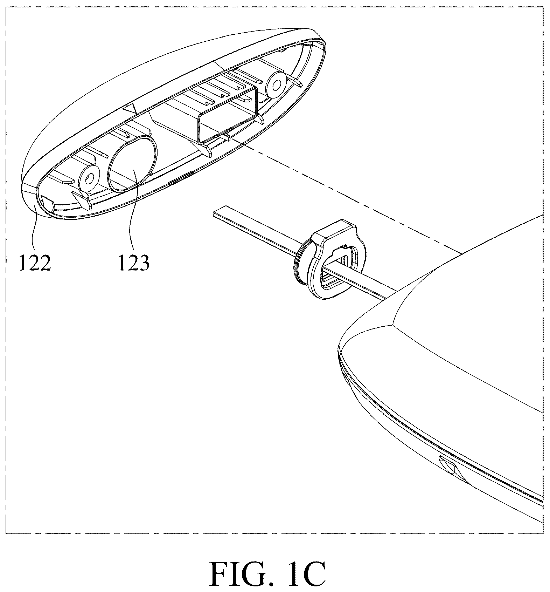

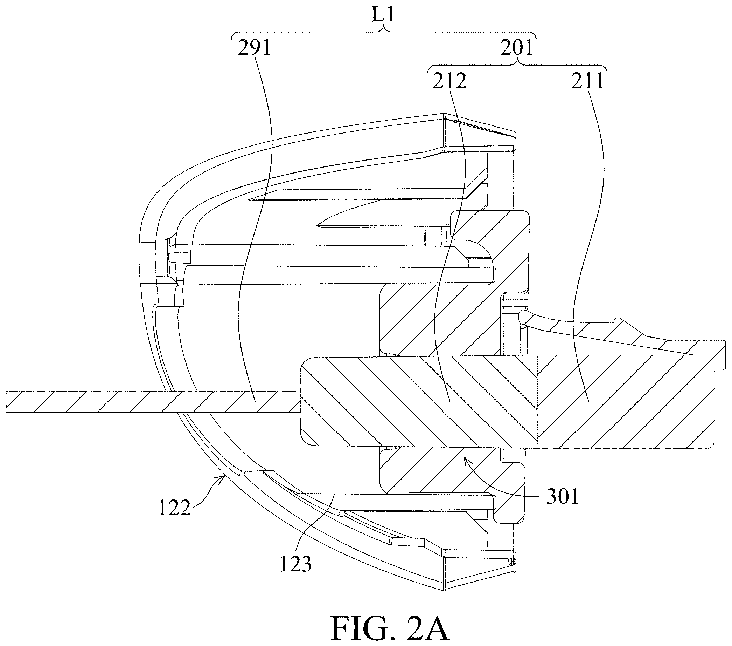

Referring to FIG. 1C and FIG. 2A, the cover lid 122 includes a mounting slot 123 in one embodiment, and the water proof member 301 is disposed in the mounting slot 123. The waterproof member 301 is tightly fitted to an inner wall of the mounting slot 123.

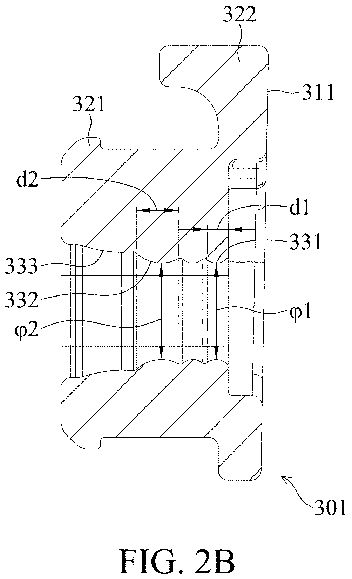

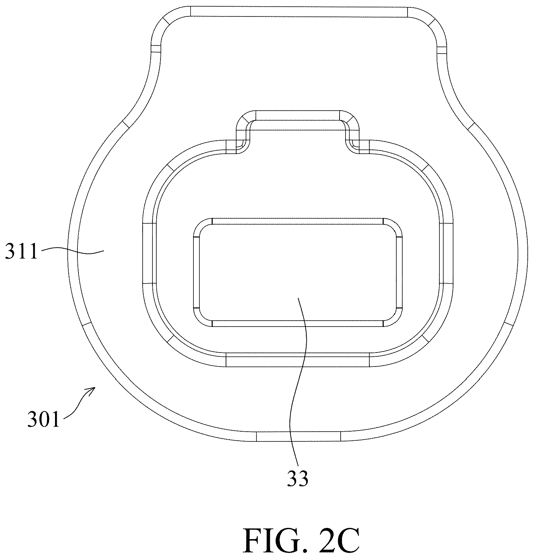

Referring to FIG. 1B, FIG. 2B, and FIG. 2C, the device body 101 includes a body surface 131 in one embodiment. The socket 111 is located on the body surface 131. The waterproof member 301 includes an abutting surface 311, and the abutting surface 311 is in contact with the body surface 131. The abutting surface 311 of the waterproof member 301 contacting the body surface 131 of the device body 101 provides waterproof protection to the electronic device D1.

Referring to FIG. 2A, FIG. 2B, and FIG. 2C, in one embodiment, the waterproof member 301 includes a rib 321 and a flange 322. The abutting surface 311 is located on the flange 322, and the flange 322 is located at one end of the waterproof member 301. The rib 321 is located at another end of the waterproof member 301 and is tightly fitted to the inner wall of the mounting slot 123. The rib 321 facilitates the installation of the waterproof member 301 to the cover lid 122 to be more convenient and prevents the waterproof member 301 from sliding in the mounting slot 123.

Referring to FIG. 1B, the cover lid 122 is fastened and/or connected to the body surface 131 through a fastener 124 in one embodiment. The fastener 124 is, for example, a bolt or a screw.

Referring to FIG. 2A, FIG. 2B, and FIG. 2C, in one embodiment, the plug unit 201 includes a registered jack 211 and a protective sheath 212. The cable body 291 is connected to the registered jack 211. The protective sheath 212 is disposed on the cable body 291 and abuts the registered jack 211. The waterproof member 301 is sleeved over the protective sheath 212.

In one embodiment, the waterproof member 301 includes a through hole 33. A first enclosed rib 331 and a second enclosed rib 332 are formed in the through hole 33. The first enclosed rib 331 is located between the second enclosed rib 332 and the abutting surface 311. The first enclosed rib 331 has a first inner diameter φ1, and the second enclosed rib 332 has a second inner diameter φ2. The first inner diameter φ1 is smaller than the second inner diameter φ2. In one embodiment, the contact surface between the cable L1 and the through hole 33 also provides waterproof protection.

Referring to FIG. 2B, in one embodiment, the first enclosed rib 331 has a first width d1, and the second enclosed rib 332 has a second width d2. The first width d1 is smaller than the second width d2.

Referring to FIG. 2B and FIB. 2C, in one embodiment, the through hole 33 further has an enlarging portion 333, and the second enclosed rib 332 is located between the enlarging portion 333 and the first enclosed rib 331.

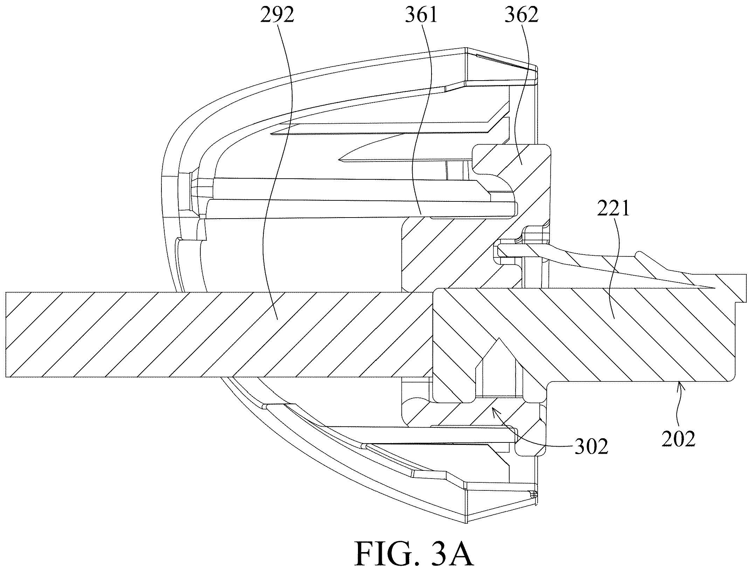

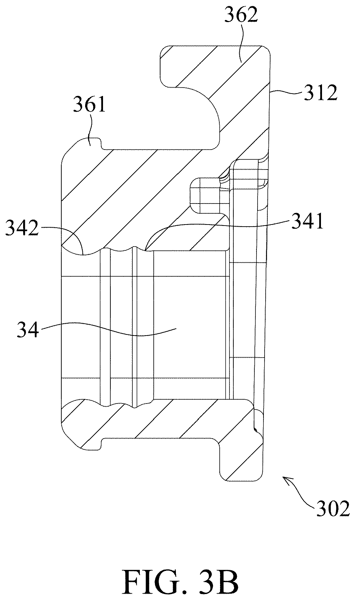

Referring to FIG. 3A and FIG. 3B, in one embodiment, the plug unit 202 includes a registered jack 221. The cable body 292 is connected to the registered jack 221, and the waterproof member is sleeved over the registered jack 221 and the cable body 292.

Referring to FIG. 3A and FIG. 3B, in one embodiment, the waterproof member 302 includes a through hole 34. A first enclosed rib 341 and a second enclosed rib 342 are formed in the through hole 34. The first enclosed rib 341 is located between the second enclosed rib 342 and the abutting surface 312. The first enclosed rib 341 abuts the registered jack 221, and the second enclosed rib 342 abuts the cable body 292.

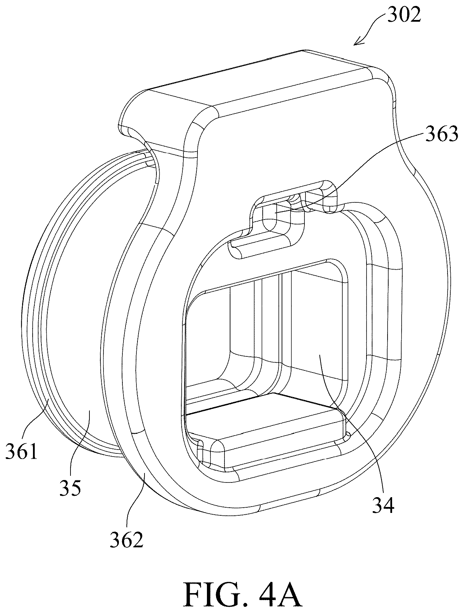

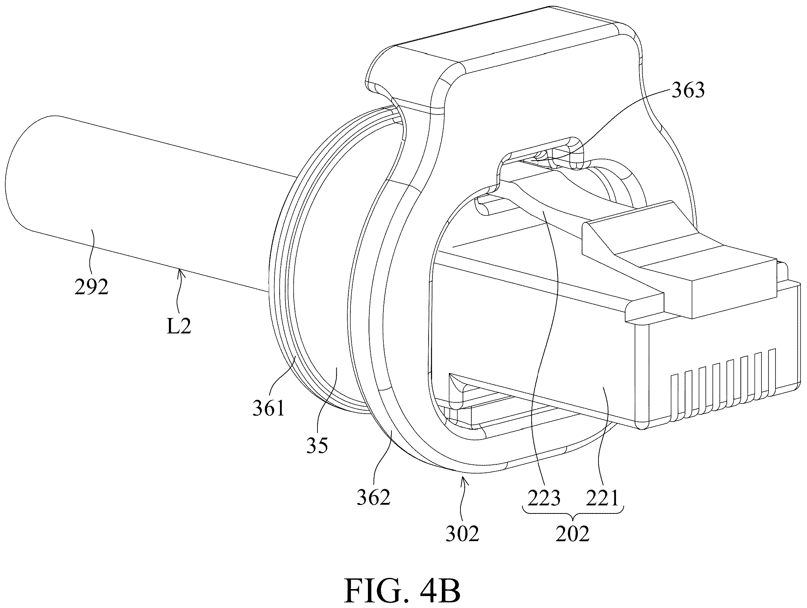

Referring to FIG. 4A and FIG. 4B, in one embodiment, the waterproof member 302 is adapted to be sleeved over a cable L2. The waterproof member 302 includes a member body 35 and the member body 35 has a through hole 34 formed therein. The cable L2 includes a plug unit 202 and a cable body 292. The plug unit 202 is disposed at one end of the cable body 292. When the plug unit 202 is passed through the through hole 34, the waterproof member 302 is sleeved over at least a portion of the plug unit 202. In one embodiment, the contact between the cable L2 and the through hole 34 also provides waterproof protection.

In one embodiment, the waterproof member 302 includes a rib 361 and a flange 362. The flange 362 is located at one end of the member body 35, and the rib 361 is located at another end of the member body 35. A recess 363 is formed on the flange 362. The plug unit 202 includes a registered jack 221, and the registered jack 221 includes an elastic arm 223 that is adapted to be placed in the recess 363. In one embodiment, the applied force must be evenly distributed around the rectangular plug unit of the cable L2 in order to achieve waterproof protection, and as such, the risk of waterproof defection caused by over-deformation due to uneven application of force is prevented. By using soft material such as rubber in the waterproof member, the cover lid 122 is able to evenly apply force on the approximately elliptical-shaped (capsule shape) waterproof member through the mounting slot 123, and the force is then further evenly distributed on the cable L2 through the squeezable characteristic of the material of the waterproof member. In another embodiment, the cross-section shape of the through hole 34 may be varied. For example, the part of the through hole 34 which corresponds to the registered jack 221 could have a rectangular cross-section, and the part of the through hole 34 which corresponds to the cable body 292 could have a round cross-section, thereby making the force be more evenly applied on the cable L2, but the present disclosure is not limited thereby.

In one embodiment, the waterproof member is made of elastic material like rubber. The waterproof member of the present disclosure has a simple structure and low cost, and moreover, it is easy to assemble and is adaptable to most cable types for providing waterproof protections. Furthermore, the waterproof member of the present disclosure is easy and convenient to assemble and disassemble for users.

## Claims

1. A waterproof member (301), adapted to be sleeved over a cable (L1), wherein the cable (L1) comprises a cable body (291) and a plug unit (201), the plug unit (201) is disposed at one end of the cable body (291), wherein the waterproof member (301) is configured to be sleeved over at least a portion of the plug unit (201), when the plug unit (201) is inserted to pass through the through hole (33), the waterproof member (301) comprising
a member body (35) comprising a through hole (34) and an elastic material;
an abutting surface (311),
a first enclosed rib (331),
a second enclosed rib (332),
wherein the first enclosed rib (331) and the second enclosed rib (332) are formed in the through hole (34), the first enclosed rib is located between the second enclosed rib and the abutting surface (311), the first enclosed rib comprises a first inner diameter (φ1), the second enclosed rib comprises a second inner diameter (φ2), **characterised in that** the first inner diameter is smaller than the second inner diameter.

2. The waterproof member (301) according to claim 1, wherein the plug unit (201) comprises a registered jack (211) and a protective sheath (212), the cable body (291) is connected to the registered jack (211), the protective sheath (212) is disposed on the cable body (291) and abuts the registered jack (211), and the waterproof member (301) is configured to be sleeved over the protective sheath (212) and/or the plug unit (202) comprises a registered jack (221) connected to the cable body (292), and the waterproof member (301) is configured to be sleeved over the registered jack (221) and the cable body (292).

3. The waterproof member according to claim 2, wherein the first enclosed rib (331) comprises a first width (d1), the second enclosed rib (332) comprises a second width (d2), and the first width (d1) is smaller than the second width (d2).

4. The waterproof member according to claim 3, wherein the through hole (34) further comprises an enlarging portion (333), and the second enclosed rib (332) is located between the enlarging portion (333) and the first enclosed rib (331).

5. The waterproof member according to claim 2, wherein the first enclosed rib (331) a is configured to abut the registered jack (221), and the second enclosed rib (332) is configured to abut the cable body (292).

6. The waterproof member according to claim 2, further comprising a rib (361) and a flange (362), wherein the flange (362) is located at one end of the member body (35), the rib (361) is located at another end of the member body (35), the flange (362) comprises a recess (363), the plug unit (202) comprises a registered jack (221) with an elastic arm (223), and the recess (363) is adapted to receive the elastic arm (223) within.

7. A electronic device comprising:
a device body (101) comprising a socket (111);
a cable (L1), comprising a plug unit (201) and a cable body (291), wherein the plug unit (201) is disposed at one end of the cable body (291) and is adapted to be connected to the socket (111); and
a waterproof member (301) according to claim 1, wherein the waterproof member is sleeved over at least a portion of the plug unit (201).

8. The electronic device according to claim 7, further comprising a housing (121) and a cover lid (122), wherein the device body (101) is disposed inside the housing (121), and the waterproof member (301) is disposed inside the cover lid (122).

9. The electronic device according to claim 8, wherein the cover lid (122) comprises a mounting slot (123), the waterproof member (301) is disposed in the mounting slot (123), and the waterproof member (301) is tightly fitted to an inner wall of the mounting slot (123).

10. The electronic device according to any one of the preceding claims, wherein the device body (101) comprises a body surface (131), the socket (111) is located on the body surface (131), the waterproof member (301) comprises an abutting surface (311), and the abutting surface (311) is in contact with the body surface (131).

11. The electronic device according to claim 10, wherein the waterproof member (301) comprises a rib (321) and a flange (322), the abutting surface (311) is located on the flange (322), the flange (322) is located at one end of the waterproof member (301), the rib (321) is located at another end of the waterproof member (301), and the rib (321) is tightly fitted to the inner wall of the mounting slot (123).

12. The electronic device according to claim 10 or 11, wherein the cover lid (122) is fastened to the body surface (123).

13. The electronic device according to any one of the preceding claims, wherein the plug unit (201) comprises a registered jack (211) and a protective sheath (212), the cable body (291) is connected to the registered jack (211), the protective sheath (212) is disposed on the cable body (291) and abuts the registered jack (211), and the waterproof member (301) is sleeved over the protective sheath (212); or the plug unit (202) comprises a registered jack (221) connected to the cable body (292), and the waterproof member (302) is sleeved over the registered jack (221) and the cable body (292).

14. The electronic device according to any one of the preceding claims 10-13, wherein the first enclosed rib (331) abuts the registered jack (211), and the second enclosed rib (332) abuts the cable body (291).

15. The electronic device according to claim 14, wherein the first enclosed rib (331) comprises a first width (d1), the second enclosed rib (332) comprises a second width (d2), and the first width (d1) is smaller than the second width (d2) and/or the through hole (33) further comprises an enlarging portion (333), and the second enclosed rib (332) is located between the enlarging portion (333) and the first enclosed rib (331).

## Patentansprüche

1. Wasserdichtes Element (301), das ausgelegt ist, ein Kabel (L1) zu umhüllen, wobei das Kabel (L1) einen Kabelkörper (291) und eine Steckereinheit (201) umfasst und die Steckereinheit (201) an einem Ende des Kabelkörpers (291) angeordnet ist, wobei das wasserdichte Element (301) konfiguriert ist, zumindest einen Abschnitt der Steckereinheit (201) zu umhüllen, wenn die Steckereinheit (201) so einsetzt ist, dass sie durch das Durchgangsloch (33) verläuft, wobei das wasserdichte Element (301) einen Elementkörper (35) umfasst, der ein Durchgangsloch (34) und ein elastisches Material umfasst;
eine Anlagefläche (311);
eine erste umschlossene Rippe (331); und
eine zweite umschlossene Rippe (332),
wobei die erste umschlossene Rippe (331) und die zweite umschlossene Rippe (332) im Durchgangsloch (34) gebildet sind, die erste umschlossene Rippe zwischen der zweiten umschlossenen Rippe und der Anlagefläche (311) angeordnet ist, die erste umschlossene Rippe einen ersten Innendurchmesser (*φ*1) umfasst und die zweite umschlossene Rippe einen zweiten Innendurchmesser (*φ*2) umfasst,
**dadurch gekennzeichnet, dass** der erste Innendurchmesser kleiner als der zweite Innendurchmesser ist.

2. Wasserdichtes Element (301) nach Anspruch 1, wobei die Steckereinheit (201) einen genormten Steckverbinder (211) und einen Schutzmantel (212) umfasst, der Kabelkörper (291) mit dem genormten Steckverbinder (211) verbunden ist, der Schutzmantel (212) auf dem Kabelkörper (291) angeordnet ist und am genormten Steckverbinder (211) anliegt und das wasserdichte Element (301) konfiguriert ist, den Schutzmantel (212) zu umhüllen, und/oder die Steckereinheit (202) einen genormten Steckverbinder (221) umfasst, der mit dem Kabelkörper (292) verbunden ist, und das wasserdichte Element (301) konfiguriert ist, den genormten Steckverbinder (221) und den Kabelkörper (292) zu umhüllen.

3. Wasserdichtes Element nach Anspruch 2, wobei die erste umschlossene Rippe (331) eine erste Breite (d1) umfasst, die zweite umschlossene Rippe (332) einer zweite Breite (d2) umfasst und die erste Breite (d1) kleiner als die zweite Breite (d2) ist.

4. Wasserdichtes Element nach Anspruch 3, wobei das Durchgangsloch (34) ferner einen Vergrößerungsabschnitt (333) umfasst und die zweite umschlossene Rippe (332) zwischen dem Vergrößerungsabschnitt (333) und der ersten umschlossenen Rippe (331) angeordnet ist.

5. Wasserdichtes Element nach Anspruch 2, wobei die erste umschlossene Rippe (331) konfiguriert ist, am genormten Steckverbinder (221) anzuliegen, und die zweite umschlossene Rippe (332) konfiguriert ist, am Kabelkörper (292) anzuliegen.

6. Wasserdichtes Element nach Anspruch 2, das ferner eine Rippe (361) und einen Flansch (362) umfasst, wobei der Flansch (362) an einem Ende des Elementkörpers (35) angeordnet ist, die Rippe (361) an einem anderen Ende des Elementkörpers (35) angeordnet ist, der Flansch (362) eine Aussparung (363) umfasst, die Steckereinheit (202) einen genormten Steckverbinder (221) mit einem elastischen Arm (223) umfasst und die Aussparung (363) ausgelegt ist, den elastischen Arm (223) darin aufzunehmen.

7. Elektronische Vorrichtung, die Folgendes umfasst:
einen Vorrichtungskörper (101), der eine Buchse (111) umfasst;
ein Kabel (L1), das ein Steckereinheit (201) und einen Kabelkörper (291) umfasst, wobei die Steckereinheit (201) an einem Ende des Kabelkörpers (291) angeordnet ist und ausgelegt ist, mit der Buchse (111) verbunden zu werden; und
ein wasserdichtes Element (301) nach Anspruch 1, wobei das wasserdichte Element zumindest einen Abschnitt der Steckereinheit (201) umhüllt.

8. Elektronische Vorrichtung nach Anspruch 7, die ferner ein Gehäuse (121) und einen Abdeckdeckel (122) umfasst, wobei der Vorrichtungskörper (101) im Inneren des Gehäuses (121) angeordnet ist und das wasserdichte Element (301) im Inneren des Abdeckdeckels (122) angeordnet ist.

9. Elektronische Vorrichtung nach Anspruch 8, wobei der Abdeckdeckel (122) einen Montageschlitz (123) umfasst, das wasserdichte Element (301) im Montageschlitz (123) angeordnet ist und das wasserdichte Element (301) an eine Innenwand des Montageschlitzes (123) eng anliegend eingepasst ist.

10. Elektronische Vorrichtung nach einem der vorhergehenden Ansprüche, wobei der Vorrichtungskörper (101) eine Körperfläche (131) umfasst, die Buchse (111) auf der Körperfläche (131) angeordnet ist, das wasserdichte Element (301) eine Anlagefläche (311) umfasst und die Anlagefläche (311) sich mit der Körperfläche (131) in Kontakt befindet.

11. Elektronische Vorrichtung nach Anspruch 10, wobei das wasserdichte Element (301) eine Rippe (321) und einen Flansch (322) umfasst, die Anlagefläche (311) auf dem Flansch (322) angeordnet ist, der Flansch (322) an einem Ende des wasserdichten Elements (301) angeordnet ist, die Rippe (321) an einem anderen Ende des wasserdichten Elements (301) angeordnet ist und die Rippe (321) an die Innenwand des Montageschlitzes (123) eng anliegend angefügt ist.

12. Elektronische Vorrichtung nach Anspruch 10 oder 11, wobei der Abdeckdeckel (122) an der Körperfläche (123) befestigt ist.

13. Elektronische Vorrichtung nach einem der vorhergehenden Ansprüche, wobei die Steckereinheit (201) einen genormten Steckverbinder (211) und einen Schutzmantel (212) umfasst, der Kabelkörper (291) mit dem genormten Steckverbinder (211) verbunden ist, der Schutzmantel (212) auf dem Kabelkörper (291) angeordnet ist und am genormten Steckverbinder (211) anliegt und das wasserdichte Element (301) den Schutzmantel (212) umhüllt; oder die Steckereinheit (202) einen genormten Steckverbinder (221) umfasst, der mit dem Kabelkörper (292) verbunden ist, und das wasserdichte Element (302) den genormten Steckverbinder (221) und den Kabelkörper (292) umhüllt.

14. Elektronische Vorrichtung nach einem der vorhergehenden Ansprüche 10-13, wobei die erste umschlossene Rippe (331) am genormten Steckverbinder (211) anliegt und die zweite umschlossene Rippe (332) am Kabelkörper (291) anliegt.

15. Elektronische Vorrichtung nach Anspruch 14, wobei die erste umschlossene Rippe (331) eine erste Breite (d1) umfasst, die zweite umschlossene Rippe (332) eine zweite Breite (d2) umfasst und die erste Breite (d1) kleiner als die zweite Breite (d2) ist und/oder das Durchgangsloch (33) ferner einen Vergrößerungsabschnitt (333) umfasst und die zweite umschlossene Rippe (332) zwischen dem Vergrößerungsabschnitt (333) und der ersten umschlossenen Rippe (331) angeordnet ist.

## Revendications

1. Élément imperméable à l'eau (301), adapté pour être glissé sur un câble (L1), dans lequel le câble (L1) comporte un corps de câble (291) et une unité de fiche (201), l'unité de fiche (201) est disposée à une extrémité du corps de câble (291), dans lequel l'élément imperméable à l'eau (301) est configuré pour être glissé sur au moins une partie de l'unité de fiche (201), lorsque l'unité de fiche (201) est insérée pour passer à travers un trou traversant (33), l'élément imperméable à l'eau (301) comportant :
un corps d'élément (35) comportant un trou traversant (34) et un matériau élastique ;
une surface en butée (311),
une première nervure fermée (331), et
une seconde nervure fermée (332),
dans lequel la première nervure fermée (331) et la seconde nervure fermée (332) sont formées dans le trou traversant (34), la première nervure fermée est située entre la seconde nervure fermée et la surface en butée (311), la première nervure fermée a un premier diamètre intérieur (φ1), la seconde nervure fermée a un second diamètre intérieur (φ2),
**caractérisé en ce que** le premier diamètre intérieur est inférieur au second diamètre intérieur.

2. Élément imperméable à l'eau (301) selon la revendication 1, dans lequel l'unité de fiche (201) comprend une prise correspondante (211) et une gaine de protection (212), le corps de câble (291) est relié à la prise correspondante (211), la gaine de protection (212) est disposée sur le corps de câble (291) et vient en butée contre la prise correspondante (211), et l'élément imperméable à l'eau (301) est configuré pour être glissé sur la gaine de protection (212) et/ou l'unité de fiche (202) comporte une prise correspondante (221) reliée au corps de câble (292), et l'élément imperméable à l'eau (301) est configuré pour être glissé sur la prise correspondante (221) et le corps de câble (292).

3. Élément imperméable à l'eau selon la revendication 2, dans lequel la première nervure fermée (331) a une première largeur (d1), la seconde nervure fermée (332) a une seconde largeur (d2), et la première largeur (d1) est inférieure à la seconde largeur (d2).

4. Élément imperméable à l'eau selon la revendication 3, dans lequel le trou traversant (34) comporte en outre une partie élargie (333), et la seconde nervure fermée (332) est située entre la partie élargie (333) et la première nervure fermée (331).

5. Élément imperméable à l'eau selon la revendication 2, dans lequel la première nervure fermée (331) est configurée pour venir en butée contre la prise correspondante (221), et la seconde nervure fermée (332) est configurée pour venir en butée contre le corps de câble (292).

6. Élément imperméable à l'eau selon la revendication 2, comportant en outre une nervure (361) et une collerette (362), dans lequel la collerette (362) est située à une extrémité du corps d'élément (35), la nervure (361) est située à une autre extrémité du corps d'élément (35), la collerette (362) comporte un évidement (363), l'unité de fiche (202) comporte une prise correspondante (221) avec un bras élastique (223), et l'évidement (363) est adapté pour recevoir le bras élastique (223) à l'intérieur.

7. Dispositif électronique comportant :
un corps de dispositif (101) comportant une embase (111) ;
un câble (L1), comportant une unité de fiche (201) et un corps de câble (291), dans lequel l'unité de fiche (201) est disposée à une extrémité du corps de câble (291) et est adaptée pour être reliée à l'embase (111) ; et
un élément imperméable à l'eau (301) selon la revendication 1, dans lequel l'élément imperméable à l'eau est glissé sur au moins une partie de l'unité de fiche (201).

8. Dispositif électronique selon la revendication 7, comportant en outre un boîtier (121) et un couvercle de recouvrement (122), dans lequel le corps de dispositif (101) est disposé à l'intérieur du boîtier (121), et l'élément imperméable à l'eau (301) est disposé à l'intérieur du couvercle de recouvrement (122).

9. Dispositif électronique selon la revendication 8, dans lequel le couvercle de recouvrement (122) comporte une encoche de montage (123), l'élément imperméable à l'eau (301) est disposé dans l'encoche de montage (123), et l'élément imperméable à l'eau (301) est monté de manière serrée sur une paroi intérieure de l'encoche de montage (123).

10. Dispositif électronique selon l'une quelconque des revendications précédentes, dans lequel le corps de dispositif (101) comporte une surface de corps (131), l'embase (111) est située sur la surface de corps (131), l'élément imperméable à l'eau (301) comporte une surface en butée (311), et la surface en butée (311) est en contact avec la surface de corps (131).

11. Dispositif électronique selon la revendication 10, dans lequel l'élément imperméable à l'eau (301) comporte une nervure (321) et une collerette (322), la surface en butée (311) est située sur la collerette (322), la collerette (322) est située à une extrémité de l'élément imperméable à l'eau (301), la nervure (321) est située à une autre extrémité de l'élément imperméable à l'eau (301), et la nervure (321) est montée de manière serrée sur la paroi intérieure de l'encoche de montage (123).

12. Dispositif électronique selon la revendication 10 ou 11, dans lequel le couvercle de recouvrement (122) est fixé à la surface de corps (131).

13. Dispositif électronique selon l'une quelconque des revendications précédentes, dans lequel l'unité de fiche (201) comporte une prise correspondante (211) et une gaine de protection (212), le corps de câble (291) est relié à la prise correspondante (211), la gaine de protection (212) est disposée sur le corps de câble (291) et vient en butée contre la prise correspondante (211), et l'élément imperméable à l'eau (301) est glissé sur la gaine de protection (212) ; ou l'unité de fiche (202) comporte une prise correspondante (221) reliée au corps de câble (292), et l'élément imperméable à l'eau (302) est glissé sur la prise correspondante (221) et le corps de câble (292).

14. Dispositif électronique selon l'une quelconque des revendications 10 à 13 précédentes, dans lequel la première nervure fermée (331) vient en butée contre la prise correspondante (211), et la seconde nervure fermée (332) vient en butée contre le corps de câble (291).

15. Dispositif électronique selon la revendication 14, dans lequel la première nervure fermée (331) a une première largeur (d1), la seconde nervure fermée (332) a une seconde largeur (d2), et la première largeur (d1) est inférieure à la seconde largeur (d2) et/ou le trou traversant (33) comporte en outre une partie élargie (333), et la seconde nervure fermée (332) est située entre la partie élargie (333) et la première nervure fermée (331).
